# EUROPÄISCHE PATENTANMELDUNG

(11) **EP 4 249 807 A1**
(43) Veröffentlichungstag der Anmeldung: **27.09.2023**
(21) Anmeldenummer: 23156216.6
(22) Anmeldetag: 13.02.2023
(51) Int. Cl.: F24C 7/08, A47J 37/00, A47L 15/42, D06F 34/32, H05B 6/64, H01L 27/15, G02B 5/00

(54) **ANZEIGEELEMENT UND ELEKTRISCHES HAUSHALTSGERÄT**

(30) Priorität: 21.03.2022 BE 202205200
(71) Anmelder: Miele & Cie. KG, 33332 Gütersloh (DE)
(72) Erfinder: Schneider, Daniel, 33415 Verl (DE)

(57) **Zusammenfassung**

Die Erfindung betrifft ein Anzeigeelement, aufweisend
- eine Geräteblende (4) mit einer Außenseite (41) und einer Innenseite (42);
- eine auf der Geräteblende (4) angeordnete Streuschicht (3), und
- ein Matrix-Leuchtmittel (1), das auf Innenseite (42) der Geräteblende (4) angeordnet ist,

dadurch gekennzeichnet, dass das Matrix-Leuchtmittel als Mikro-LED-Matrix (1) mit einer Vielzahl von Mikro-LEDs (2) ausgebildet ist. Ferner betrifft die Erfindung ein elektrisches Haushaltsgerät, das ein derartiges Anzeigeelement aufweist.

## Beschreibung

Die Erfindung betrifft ein Anzeigeelement und ein elektrisches Haushaltsgerät. Insbesondere betrifft die Erfindung ein Anzeigeelement, das eine Geräteblende mit einer Außenseite und einer Innenseite, eine auf oder in der Geräteblende angeordnete Streuschicht und ein Matrix-Leuchtmittel aufweist, das auf Innenseite der Geräteblende angeordnet ist, sowie ein elektrisches Haushaltsgerät, das ein solches Anzeigeelement aufweist.

Bei Anzeigeelementen mit einer Geräteblende, die eine lichtstreuende Schicht z.B. in Form einer Dekorbedruckung aufweist, besteht das Problem, dass die streuenden Anteile zu einer erheblichen Streuung des zur Anzeige erforderlichen emittierten Lichts führen, so dass der darzustellende Inhalt oder die optisch angezeigte Darstellung unscharf wird. Um diesen Effekt zu verhindern oder zumindest zu reduzieren, kann ein Matrix-Leuchtmittel, beispielsweise in Form einer LED-Siebensegment-Anzeige, unmittelbar hinter einer Seite der Streuschicht angeordnet werden, die von der Geräteblende abgewandt ist. Die Integration kann jedoch aufgrund des dafür erforderlichen Bauraums schwierig sein. Auch kann die Größe des dargestellten Bereichs sehr begrenzt sein. Zudem ist ein so genannter Verschwindeeffekt der Anzeige vorteilhaft. Damit ist gemeint, dass im ausgeschalteten Zustand des Matrix-Leuchtmittels bzw. der Anzeige unter üblichen Beleuchtungsbedingungen das Matrix-Leuchtmittel bzw. die Anzeige hinter der homogen beschichteten Blende für ein menschliches Auges nicht zu erkennen ist. Dies ist insbesondere bei hellen Blendenbedruckungen bzw. - beschichtungen bzw. Bedruckungen bzw. Beschichtungen, die streuende Farbpigmente enthalten, schwierig.

Der Erfindung stellt sich somit das Problem, ein Anzeigeelement und ein elektrisches Haushaltsgerät mit einer konturscharfen Anzeige mit Verschwindeeffekt, der auch bei streuenden Dekorbedruckungen bzw. Blendenbeschichtungen gut funktioniert, bereitzustellen, die einen möglichst geringen Bauraum aufweisen.

Erfindungsgemäß wird dieses Problem durch ein Anzeigeelement mit den Merkmalen des Patentanspruchs 1 und ein elektrisches Haushaltsgerät mit den Merkmalen des Patentanspruchs 12 gelöst. Vorteilhafte Ausgestaltungen und Weiterbildungen der Erfindung ergeben sich aus den nachfolgend beschriebenen Unteransprüchen.

Erfindungsgemäß ist vorgesehen, dass das Matrix-Leuchtmittel bzw. die Anzeige als Mikro-LED-Matrix mit einer Vielzahl von Mikro-LEDs ausgebildet ist. Eine Mikro-LED ist eine mikroskopisch kleine Leuchtdiode, üblicherweise mit Abmessungen der Licht-emittierenden Bereiche, die in der Größenordnung kleiner gleich einem Millimeter betragen. Diese Mikro-LEDs weisen geometrischen Strukturen und Dimensionen im Mikrometerbereich,q d.h. im Bereich von 0,1 bis 2500 µm auf. Die Mikro-LED weist bevorzugt eine Leuchtfläche im Quadrat-Mikrometerbereich auf. Die Mikro-LED-Matrix basiert daher auf einer Anordnung kleiner, einzelne Bildelemente bildender Leuchtdioden in Zeilen und Spaltenanordnung. Die Bildelemente sind hierbei selbstleuchtend, dimmbar und komplett abschaltbar und benötigen deshalb keine Hintergrundbeleuchtung. Es wird daher auf diese Weise ein LED-Matrix-Display realisiert. Die Vielzahl von Mikro-LEDs können matrixartig auf einem Chip als Substrat angeordnet sein. Alternativ kann die Vielzahl von Mikro-LEDs als einzelne Bauelemente angeordnet sein, die matrixförmig auf einem Substrat (z.B. Leiterkarte, Metallkernleiterkarte, Flexleiter, Folie, Glas, Keramik o.ä.) angeordnet sind. Dadurch wird ein Anordnen der Mikro-LEDs mit einem sehr geringen Abstand zueinander ermöglicht. Die Mikro-LEDs sind als individuell ansteuerbare Matrix angeordnet, so dass damit dynamische, flexible Anzeigeninhalte realisiert werden können.

Ein mit der Erfindung erzielbarer Vorteil besteht neben einer Bereitstellung einer deutlich höheren Auflösung bei darzustellenden Elementen im Vergleich zur Siebensegmentanzeige darin, dass auch ein Darstellen von Fotos und Videos möglich ist. Zudem können Anzeigen beliebiger Größe in X- und Y-Richtung bei vergleichsweise geringer, räumlicher Ausdehnung in Z-Richtung realisiert werden. Da jeder Bildpunkt für sich einer Mikro-LED entspricht, lassen sich größere Helligkeitswerte erreichen. Trotz der in oder an der Geräteblende vorgesehenen Streuschicht werden konturscharfe Darstellungen mit einem guten Verschwindeeffekt erzielt.

In einer bevorzugten Ausführungsform weisen die Vielzahl von Mikro-LEDs einen Abstand von weniger als 2,5 mm zueinander auf. Bevorzugter weisen die Vielzahl von Mikro-LEDs einen Abstand von weniger als 1,0 mm auf. Besonders bevorzugt weisen die Vielzahl von Mikro-LEDs einen Abstand von weniger als 0,5 mm zueinander auf. Der Abstand bezieht sich dabei beispielsweise auf Randbereiche der Mikro-LEDs, die nicht mehr oder so wenig Licht emittieren, dass diese nicht signifikant, d.h. <10% zur gesamten emittierten Lichtintensität beitragen.

Bevorzugt ist die Streuschicht auf der Innenseite bzw. benutzerabgewandten Seite der Geräteblende angeordnet. Durch das Anordnen der LED-Matrix auf der Seite der Geräteblende, auf der die Streuschicht angebracht bzw. aufgebracht ist, kann sowohl ein guter Verschwindeeffekt im ausgeschalteten Zustand des Anzeigeelements als auch eine sehr konturscharfe Darstellung im Betrieb erzielt werden. Werden die Mikro-LEDs, die die Bildpunkte der LED-Matrix bilden, in einem Abstand von z.B. deutlich weniger als 2,0 mm zueinander positioniert, können bei direkter Anordnung hinter einer Geräteblende mit auf der Innenseite angeordneter Streuschicht Darstellungen von Symbolen, Bildern, Animationen, Videos etc. mit gut funktionierendem Verschwindeeffekt erzielt werden. Die Streuschicht ist bevorzugt als transparente oder transluzente Beschichtung und/oder Bedruckung der Geräteblende ausgebildet. Das Anzeigeelement kann beispielsweise eine Geräteblende mit weißer Bedruckung als Streuschicht aufweisen.

In einer bevorzugten Ausführungsform ist eine Matrix-Anzeigeoberfläche der Mikro-LED-Matrix in einem Abstand von weniger als 1 mm zur Streuschicht angeordnet. Durch Bereitstellen eines möglichst geringen Abstands zwischen der Mikro-LED-Matrix und der streuenden Fläche wird eine scharfe Darstellung hinter der Streuschicht gewährleistet. Bevorzugt liegen die angrenzenden Bauelemente der Mikro-LED-Matrix direkt, d.h. in mechanischem Kontakt, an der Innenseite bzw. benutzerabgewandten Seite der Geräteblende an.

Bevorzugt liegt die LED-Mikro-Matrix direkt an der Streuschicht an. Alternativ bevorzugt ist die LED-Mikro-Matrix über eine vermittelnde Haftschicht mit dieser verbunden. Die Haftschicht kann als Feststoff oder als Gel oder als Flüssigkeit ausgebildet sein. Die Haftschicht ist bevorzugt im Brechungsindex an die Geräteblende angepasst.

Wird die LED-Matrix-Anzeige bewusst mit einem geringen Abstand (kleiner 1,0 mm) zwischen der Oberfläche der Anzeige und der Rückseite der Geräteblende betrieben, kann man sich die aus dem Abstand resultierende Unschärfe auch zunutze machen, indem diese als eine Art "Weichzeichner" wirkt. Sämtliche dargestellten Anzeigeninhalte wirken dadurch weniger pixelig und es entsteht der Eindruck einer höheren Auflösung, als die Anzeige tatsächlich ermöglicht.

In einer bevorzugten Ausführungsform sind die Vielzahl von Mikro-LEDs einfarbig ausgebildet. Dann erscheinen die Bildpunkte ebenfalls einfarbig. Alternativ bevorzugt ist die Vielzahl von Mikro-LEDs mehrfarbig ausgebildet. Dann sind die Bildpunkte in verschiedenen Farben darstellbar. Als Mikro-LEDs können sämtliche bekannten LED-Farben verwendet werden. Bevorzugt ist die Vielzahl von Mikro-LEDs in der mehrfarbigen Variante als RGB-(Rot-Grün-Blau)-LED(s) zur additiven Farbmischung beliebiger Farbtöne ausgebildet. Die Mikro-LED-Matrix kann ausschließlich einfarbige Mikro-LEDs oder ausschließlich mehrfarbige LEDs oder eine Kombination aus beiden aufweisen.

In einer bevorzugten Ausführungsform ist die Geräteblende transparent oder transparent eingefärbt ausgebildet. Beispielsweise ist die Geräteblende weiß, grau oder schwarz eingefärbt.

Bevorzugt weist das Anzeigeelement weiterhin eine fensterlose Ausbildung der Geräteblende auf. Damit wird eine vollkommen homogene, geschlossene Blendenbedruckung möglich, die im ausgeschalteten Zustand eine homogene Anmutung erhält. Alternativ bevorzugt kann das Anzeigeelement einen Dekordruck als Fenster für die Geräteblende aufweisen. Beispielsweise können somit temporär ergänzende Darstellungen einfacher Animationen, Symbole, Werte, Texte etc. außerhalb des eigentlichen Anzeigebereiches realisieren wie insbesondere Uhrzeit, Kurzzeittimer, Temperaturen, Handlungsempfehlungen, Hinweise, Warnungen, Betriebsarten usw.

In einer bevorzugten Ausführungsform weist das Anzeigeelement weiterhin eine Touchbedienung z.B. in Form einer kapazitiven Bedienung auf der Geräteblende auf der benutzerabgewandten Seite auf. Diese kann als Bestandteil (z.B. Bedruckung, Beschichtung o.ä.) der eigentlichen Geräteblende oder aber als zusätzliches Bauteil, das auf der benutzerabgewandten Seite der Blende angeordnet ist, realisiert sein. Dadurch wird die Anzeige mit einer Touchbedienung kombiniert, um ein Touch-Screen oder ein Touch-Display bereitzustellen. Dadurch wird eine individuelle Interaktion eines Nutzers mit definierten Bereichen des Anzeigeelements ermöglicht. Um eine scharfe Darstellung weiterhin zu gewährleisten, ist ein Abstand zwischen der Mikro-LED-Matrix und der Innenseite der Geräteblende möglichst gering. Bevorzugt werden entsprechende kapazitive Beschichtungen für eine kapazitive Bedienung (z.B. segmentiert oder hochaufgelöst) insbesondere direkt auf die Innenseite der Geräteblende aufgebracht, d.h. ohne Einsatz eines zusätzlichen Substrates.

Bevorzugt streut die Streuschicht bzw. Dekorschicht einfallendes sichtbares Licht mit einer weißen oder hellgrauen Anmutung. Weiterhin bevorzugt ist die Geräteblende weiß eingefärbt. In diesem Fall muss die Materialstärke der Geräteblende jedoch ggf. möglichst gering sein, damit das Licht der Anzeige nicht zu stark gestreut wird.

Die Erfindung betrifft ferner ein elektrisches Haushaltsgerät, das ein Anzeigeelement nach einer oder mehreren der vorstehend beschriebenen Ausführungsformen aufweist.

In einer bevorzugten Ausführungsform ist das elektrische Haushaltsgerät ein Backofen, ein Dampfgarer, ein Kaffeevollautomat, ein Pizzaofen, ein Herd, eine Mikrowelle, eine Spülmaschine wie ein Geschirrspüler oder ein Laborspüler, ein Waschautomat, ein Trockenautomat und/oder Kombinationen hieraus. Eine Kombination aus Wasch- und Trockenautomat wird auch als Waschtrockner bezeichnet. Bei dem elektrischen Haushaltsgerät kann es sich um ein privat oder gewerblich genutztes Gerät handeln.

Ein Ausführungsbeispiel der Erfindung ist in den Zeichnungen rein schematisch dargestellt und wird nachfolgend näher beschrieben. Es zeigen schematisch und nicht maßstabsgerecht
- Fig. 1: eine Querschnittsansicht eines erfindungsgemäßen Anzeigeelements;
- Fig. 2: eine Draufsicht auf die Mikro-LED-Matrix des in Fig. 1 gezeigten Anzeigeelements; und
- Fig. 3: eine vergrößerte Detailansicht der in Fig. 2 gezeigten Mikro-LED-Matrix.

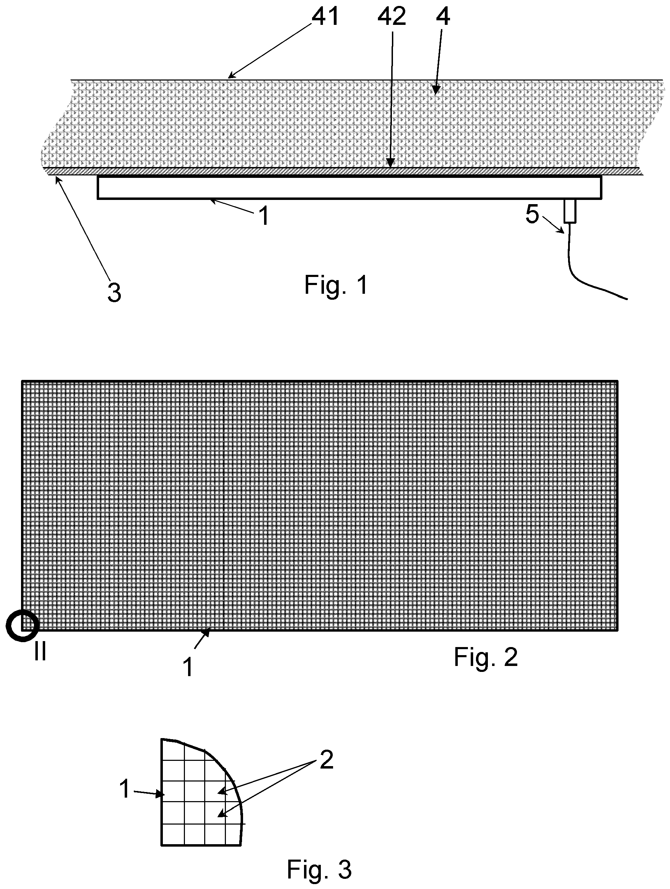

Fig. 1 zeigt eine Querschnittsansicht eines erfindungsgemäßen Anzeigeelements. Das Anzeigeelement weist eine Geräteblende 4 mit einer Außenseite 41 und einer Innenseite 42, eine auf der Geräteblende 4 angeordnete Streuschicht 3, und ein Matrix-Leuchtmittel auf, das auf der Innenseite 42 der Geräteblende 4 angeordnet und als Mikro-LED-Matrix 1 ausgebildet ist. Die Streuschicht 3 ist ebenfalls auf der Innenseite 42 der Geräteblende 4 angeordnet. Die Mikro-LED-Matrix 1 liegt direkt an der Streuschicht 3 an. In diesem Ausführungsbeispiel ist die Mikro-LED-Matrix 1 auf mechanische Weise flächig auf die Geräteblende 4 gepresst bzw. angedrückt. Dies kann durch Anpress- bzw. Andrückmittel geschehen, die in Figur 1 nicht gezeigt sind. Beispielsweise kann dies durch Rahmen-Elemente realisiert werden, die entlang der Außenkanten des Schichtpaketes von Geräteblende 4 und Mikro-LED-Matrix 1 angeordnet sind.

An der Mikro-LED-Matrix 1 ist weiterhin eine Verbindungsleitung 5 zur elektrischen Verbindung angeordnet. Über diese Verbindungsleitung 5 werden die einzelnen LED-Matrix-Bildpunkte angesteuert.

Fig. 2 zeigt eine Draufsicht auf die Mikro-LED-Matrix des in Fig. 1 gezeigten Anzeigeelements. Das Matrix-Leuchtmittel ist als Mikro-LED-Matrix 1 mit einer Vielzahl von Mikro-LEDs 2 ausgebildet ist, die matrixartig in Zeilen und Spalten angeordnet sind. Die einzelnen Mikro-LEDs bilden dabei einzelne Bildpunkte der Mikro-LED-Matrix 1.

Fig. 3 zeigt eine vergrößerte Detailansicht der in Fig. 2 gezeigten Mikro-LED-Matrix. Die Vielzahl von Mikro-LEDs 2 weisen von Mitte einer einzelnen Mikro-LED zur Mitte der benachbarten Mikro-LED gemessen einen Abstand von weniger als 2,5 mm zueinander auf.

### Bezugszeichenliste

- 1: Mikro-LED-Matrix
- 2: Mikro-LED
- 3: Streuschicht
- 4: Geräteblende
- 5: Verbindungsleitung
- 41: Außenseite
- 42: Innenseite

## Patentansprüche

1. Anzeigeelement, aufweisend
- eine Geräteblende (4) mit einer Außenseite (41) und einer Innenseite (42),
- eine in oder auf der Geräteblende (4) angeordnete Dekorschicht bzw. Streuschicht (3), und
- ein Matrix-Leuchtmittel (1), das auf der Innenseite (42) der Geräteblende (4) angeordnet ist,
**dadurch gekennzeichnet, dass**
das Matrix-Leuchtmittel als Mikro-LED-Matrix (1) mit einer Vielzahl von Mikro-LEDs (2) ausgebildet ist.

2. Anzeigeelement nach Anspruch 1, **dadurch gekennzeichnet, dass** die Vielzahl von Mikro-LEDs einen Abstand von weniger als 2,5 mm, bevorzugt weniger als 1,0 mm, besonders bevorzugt weniger als 0,5 mm, zueinander aufweisen.

3. Anzeigeelement nach Anspruch 1 oder 2, **dadurch gekennzeichnet, dass** die Streuschicht (3) auf der Innenseite (42) der Geräteblende (4) angeordnet ist.

4. Anzeigeelement nach Anspruch 3, **dadurch gekennzeichnet, dass** eine Matrix-Anzeigeoberfläche der Mikro-LED-Matrix (1) in einem Abstand von weniger als 1 mm zur Streuschicht (3) angeordnet ist.

5. Anzeigeelement nach einem der vorangehenden Ansprüche, **dadurch gekennzeichnet, dass** die LED-Mikro-Matrix (1) direkt an der Streuschicht (3) anliegt oder über eine vermittelnde Haftschicht mit dieser verbunden ist.

6. Anzeigeelement nach einem der vorangehenden Ansprüche, **dadurch gekennzeichnet, dass** die Vielzahl von Mikro-LEDs (2) einfarbig ausgebildet ist.

7. Anzeigeelement nach einem der vorangehenden Ansprüche, **dadurch gekennzeichnet, dass** die Vielzahl von Mikro-LEDs (2) mehrfarbig, bevorzugt als RGB-LED(s), ausgebildet ist.

8. Anzeigeelement nach einem der vorangehenden Ansprüche, **dadurch gekennzeichnet, dass** die Geräteblende (4) transparent oder transparent eingefärbt ausgebildet ist.

9. Anzeigeelement nach einem der vorangehenden Ansprüche, **gekennzeichnet durch** eine fensterlose Ausbildung der Geräteblende (4).

10. Anzeigeelement nach einem der vorangehenden Ansprüche, **gekennzeichnet durch** eine kapazitive Beschichtung der Geräteblende (4) auf ihrer Innenseite (42).

11. Anzeigeelement nach einem der vorangehenden Ansprüche, **dadurch gekennzeichnet, dass** die transluzente Streuschicht bzw. Dekorschicht (3) einfallendes sichtbares Licht entsprechend der Farbe der Schicht reflektiert.

12. Elektrisches Haushaltsgerät, aufweisend ein Anzeigeelement nach einem der vorangehenden Ansprüche.
